# EUROPEAN PATENT SPECIFICATION

(11) **EP 1 433 207 B1**
(45) Date of publication and mention of the grant of the patent: **19.08.2009**
(21) Application number: 02785901.6
(22) Date of filing: 04.10.2002
(51) Int. Cl.: H01L 31/18, C23C 14/06, C23C 14/58, H01L 31/072, H01L 31/0224

(54) **A PROCESS FOR LARGE-SCALE PRODUCTION OF CDTE/CDS THIN FILM SOLAR CELLS**
VERFAHREN ZUR GROSSTECHNISCHEN HERSTELLUNG VON CDTE/CDS DÜNNSCHICHT-SOLARZELLEN
PROCEDE PERMETTANT LA PRODUCTION A GRANDE ECHELLE DE PHOTOPILES EN COUCHES MINCES DE CDTE/CDS

(30) Priority: 05.10.2001 IT LU20010008 U; 17.10.2001 IT LU20010011 U; 17.10.2001 IT LU20010012 U
(43) Date of publication of application: 30.06.2004
(73) Proprietor: SOLAR SYSTEMS & EQUIOMENTS S.R.L., 55049 Viareggio (IT)
(72) Inventor: ROMEO, Nicola, I-43100 Parma (IT); BOSIO, Alessio, I-43100 Parma (IT); ROMEO, Alessandro, I-43100 Parma (IT)
(74) Representative: Bardini, Marco Luigi
(86) International application number: PCT/IT2002/000634
(87) International publication number: WO 2003/032406

(56) References cited:
- EP-A- 1 160 880
- EP-A- 1 160 880
- US-A- 4 207 119
- US-A- 5 304 499
- US-A- 5 304 499
- US-A- 5 916 375
- ROMEO N ET AL: "A highly efficient and stable CdTe/CdS thin film solar cell" SOLAR ENERGY MATERIALS AND SOLAR CELLS, ELSEVIER SCIENCE PUBLISHERS, AMSTERDAM, NL, vol. 58, no. 2, June 1999 (1999-06), pages 209-218, XP004177956 ISSN: 0927-0248
- ROMEO A ET AL: "Recrystallization in CdTe/CdS" THIN SOLID FILMS, ELSEVIER-SEQUOIA S.A. LAUSANNE, CH, vol. 361-362, no. 1, February 2000 (2000-02), pages 420-425, XP004187511 ISSN: 0040-6090
- ROMEO N ET AL: "A highly efficient and stable CdTe/CdS thin film solar cell" SOLAR ENERGY MATERIALS AND SOLAR CELLS, ELSEVIER SCIENCE PUBLISHERS, AMSTERDAM, NL, vol. 58, no. 2, June 1999 (1999-06), pages 209-218, XP004177956 ISSN: 0927-0248 cited in the application

## Description

### Field of the invention

The present invention relates to the field of the solar cells technology and more particularly concerns a process for the large-scale production of CdTe/CdS thin film solar cells.

### Background art of the invention

As is known, a typical configuration of a CdTe/CdS solar cell has a film sequence of the multi-layer arrangement comprising a transparent glass substrate carrying a transparent conductive oxide (TCO) film, a CdS film representing the n-conductor, a CdTe film representing the p-conductor and a metallic back-contact. A solar cell with a layer arrangement and structure of this type is disclosed, for example, in US 5304499.

The commercial float glass may be used as a transparent substrate, but, in spite of its low cost, special glasses are often preferred to avoid drawbacks of the float glass, in particular Na diffusion into TCO film.

The most common TCO is In₂O₃ containing 10% of Sn (ITO). This material has a very low resistivity on the order of 3x10⁻⁴ Ωcm and high transparency (>85%) in the visible spectrum. However, this material is made by sputtering and the ITO target after several runs forms some noodles which contain an In excess and a discharge between noodles can happen during sputtering which can damage the film. Another material which is commonly used is fluorine doped SnO₂ which however exhibits a higher resistivity close to 10⁻³ Ωcm and as a consequence a 1 µm thick layer is needed in order for the sheet resistance to be around 10 Ω/_{square}. A high TCO thickness decreases the transparency and then the photocurrent of the solar cell. Finally a novel material, namely Cd₂SnO₄ has been developed by the NREL group (X. Wu et al., Thin Solid Films, 286 (1996) 274-276)). Also this material has some drawbacks since the target is made up of a mixture of CdO and SnO₂ and, being CdO highly hygroscopic, the stability of the target may result to be unsatisfactory.

The CdS film is deposited by sputtering or Close-Spaced Sublimation (CSS) from CdS granulate material. This last technique allows the preparation of thin films at a substrate temperature much higher than that used in simple vacuum evaporation or sputtering, because substrate and evaporation source are put very close to each other at a distance of 2-6 mm and the deposition is done in the presence of an inert gas such as Ar, He or N₂ at a pressure of 10⁻¹-100 mbar. A higher substrate temperature allows the growth of a better crystalline quality material. An important characteristic of the close-spaced sublimation is a very high growth rate up to 10 µm/min, which is suitable for large-scale production.

CdTe film is deposited on top of CdS film by close-spaced sublimation (CSS) at a substrate temperature of 480-520°C. CdTe granulate is generally used as a source of CdTe which is vaporised from an open crucible.

An important step in the preparation of high efficiency CdTe/CdS solar cells is the treatment of CdTe film with CdCl₂- Most research groups use to carry out this step by depositing on top of CdTe a layer of CdCl₂ by simple evaporation or by dipping CdTe in a methanol solution containing CdCl₂ and then anneal the material in air at 400°C for 15-20 min. It is generally believed that the CdCl₂ treatment improves the crystalline quality of CdTe by increasing the size of small grains and by removing several defects in the material.

After CdCl₂ treatment, CdTe is etched in a solution of Br-methanol or in a mixture of nitric and phosphoric acid. Etching is necessary as CdO or CdTeO₃ are generally formed on the CdTe surface. CdO and/or CdTeO₃ have to be removed in order to make a good back contact onto CdTe. Besides it is believed that, since etching produces a Te-rich surface, the formation of an ohmic contact when a metal is deposited on top of CdTe is facilitated.

The electric back contact on the CdTe film is generally obtained by deposition of a film of a highly p-dopant metal for CdTe such as copper, e.g. in graphite contacts, which, upon annealing, can diffuse in the CdTe film. The use of a Sb₂Te₃ film as a back-contact in a CdTe/CdS solar cell has been disclosed by the same applicants (N. Romeo et al., Solar Energy Materials & Solar Cells, 58 (1999), 209-218)

Industrial interest towards thin films solar cells is increased in recent years also in view of the high conversion efficiency reached so far. A record 16,5% conversion efficiency has been recently reported (see X.Wu et al., 17th European Photovoltaic Solar Energy Conversion Conference, Munich, Germany, 22-26 October 2001, II, 995-1000). Therefore several efforts have been made to provide processes suitable for large-scale, in-line production of CdTe/CdS thin film solar cells.

A state-of-the-art report concerning this issue may be found in D. Bonnet, Thin Solid Films 361-362 (2000), 547-552. However, a number of problems still hinder the achievement of this result, in particular concerning some crucial steps which affect either stability and efficiency of CdTe/CdS thin film solar cells or their costs.

A major problem of the known processes is the etching step to which the CdTe surface must be submitted to remove CdO or CdTeO₃ oxides formed thereon. Since etching requires the immersion of substrates carrying the treated CdTe/CdS films into acid solutions, rinsing and drying, machinery suitable for a continuous operation presently does not exist. Another significant problem which negatively affects the stability of the TCO films, as well as the cost of the final product are the drawbacks presently encountered with the use of known TCOs, as previously mentioned. In addition to these drawbacks, known TCOs require the use of special glasses, such as borosilicate glass, to avoid the problem of Na diffusion, occurring if a soda-lime glass is used, which would damage the film.

A further problem concerns the source from which the CdS film and the CdTe film are produced by close-spaced sublimation. When small pieces of these materials containing dust are used as a sublimation source, due to a different thermal contact, some micro-particles can be overheated and then split on to the substrate together with the vapour. In order to avoid this inconvenience, complicated metallic masks are used in some cases, which make a continuous operation problematic.

### Object and Summary of the invention

It is the main object of the present invention to provide a process suitable for a large-scale production of stable and efficient CdTe/CdS thin film solar cells on a low cost substrate.

A particular object of the present invention is to provide a process of the above mentioned type in which the treatment of the CdTe film with CdCl₂ is conducted in such a way as not to require an etching treatment to remove the oxides possibly formed on the CdTe film.

A further object of the present invention is to provide a process of tne above mentioned type, in which the deposition of the TCO film is conducted in such a way that a film of very low resistivity can be deposited without formation of any metal noodles on the target and allowing the use of a inexpensive substrate.

Still another object of the invention is to provide a process of the above-mentioned type, which allows the formation of CdS and CdTe films completely free of dust.

A further object of the present invention is to provide a stable, efficient and relatively low-cost CdTe/CdS thin film solar cell.

The above object are achieved with the process for the large scale production of CdTe/CdS thin film solar cells, the main features of which are set forth in claim 1.

According to an important aspect of the invention, the treatment of the CdTe film with CdCl₂ is carried out by first forming a 100-200 nm thick layer of CdCl₂ on the CdTe film by evaporation, while keeping the substrate at room temperature; then annealing the CdCl₂ layer in a vacuum chamber at 380-420°C and 300-1000 mbar under inert gas atmosphere; and finally removing the inert gas from said chamber to produce vacuum condition, while the substrate is kept to a temperature of 350-420°C, whereby any residual CdCl₂ is evaporated from the CdTe film surface. In this way, there is no need for the etching treatment of the CdTe film and the process can be conducted in a continuous way.

According to another aspect of the invention, the TCO layer is formed by sputtering in an inert gas atmosphere containing 1-3 vol.% hydrogen and a gaseous fluoroalkyle compound, in particular CHF₃. In this way the TCO is doped whit fluorine

According to another important aspect of the invention, as a source material for the formation of the CdS and the CdTe films by sputtering or close-spaced sublimation, a Cds or, respectively, CdTe material in the form of a compact block is used.

Further features of the process according to the invention are set forth in the dependent claims.

### Brief description of the drawings

Further features and advantages of the process for large-scale production of CdTe/CdS thin film solar cells according to the present invention will be apparent from the following description of a preferred embodiment made with reference to the attached drawings, wherein:

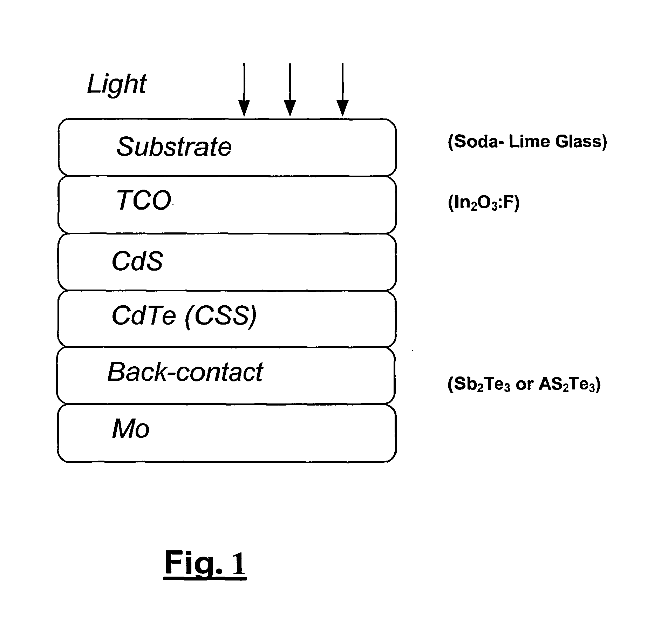

- Figure 1 is a schematic representation of the film sequence of the CdTe/CdS thin film solar cells according to the invention;

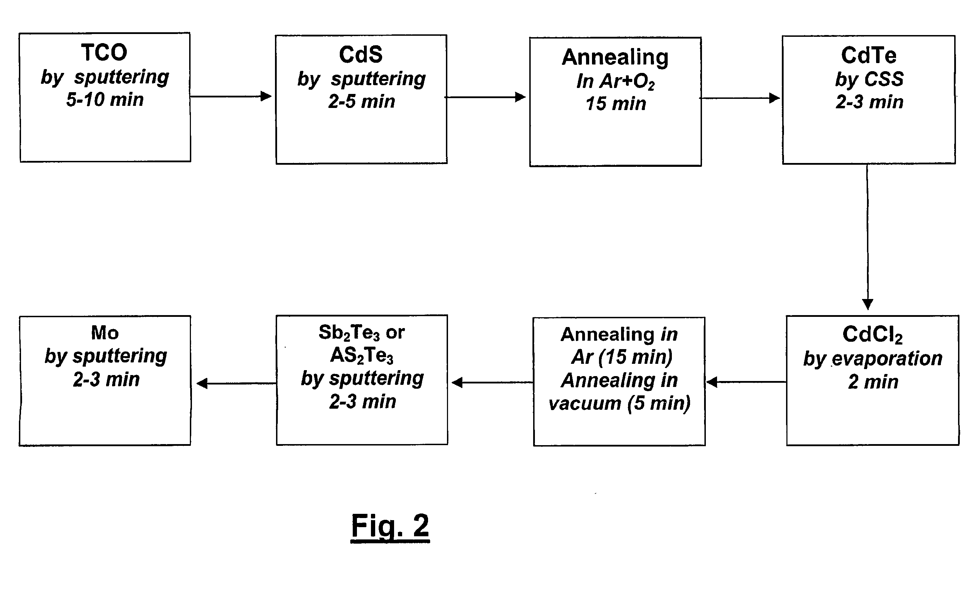

- Figure 2 is a schematic diagram of the process according to the invention.

### Description of an embodiment of the invention

With reference to the figures, the CdTe/CdS solar cells produced with the process according to the invention comprise five layers deposited in a sequence on a transparent base layer or substrate and consisting of a 300-500 nm thick layer of a transparent conducting oxide (TCO), a 80-200 nm thick layer of CdS deposited on top of the TCO layer, a 4-12 µm thick layer of CdTe on top of the CdS layer and a back contact layer formed by at least 100 nm thick layer of SB₂Te₃ and 100 nm thick layer of Mo. In particular, the transparent base substrate consists of soda-lime glass and the transparent conducting oxide is fluorine-doped (In₂O₃:F).

TCO layer consists of In₂O₃, which is doped with fluorine during the growth. The In₂O₃ target, differently from ITO, does not form any noodle. A very low resistivity is obtained by introducing in the sputtering chamber a small amount of fluorine in the form of a gaseous fluoroalkyle compound such as CHF₃ and a small amount of H₂ in the form of a mixture with an inert gas such as a Ar+H₂ mixture, in which H₂ is 20% in respect to Ar. A typical example is a 500 nm film of In₂O₃ deposited with a deposition rate higher than 10 Å/sec at a substrate temperature of 500°C, with an Ar flow-rate of 200 sccm, a CHF₃ flow-rate of 5 sccm and an Ar+H₂ flow-rate of 20 sccm. In this way, the reactive sputtering gas is composed by Ar containing 2.5 viol.% of CHF₃ and 1.8 viol.% of H₂. This film exhibits a sheet resistance of 5 Ω/_{square}, a resistivity of 2.5 x 10⁻⁴ Ωcm and a transparency higher than 85% in the wavelength range of 400-800 nm. Another characteristic of this film is its good stability and the ability to stop Na diffusion from the soda-lime glass. This has been demonstrated by making CdTe/CdS solar cells on top of this type of TCO which have shown to be very stable even if heated up to 180°C when illuminated by "ten suns" for several hours.

After deposition of the CdS film and CdTe film in the known way by sputtering or close-spaced sublimation, the CdTe film surface is treated with CdCl₂ in the following way.

200 nm of CdCl₂ are deposited by evaporation on top of CdTe film with the substrate kept at room temperature. An annealing of 15-20 min is done at 400°C in a vacuum chamber in which 500 mbar of Ar are introduced. After the annealing the chamber is evacuated keeping the substrate at 400°C for 5 min. and, since CdCl₂ has a high vapour pressure at 400°C, any residual CdCl₂ re-evaporates from the CdTe surface.

CdO or CdTeO₃ are not formed since the annealing is conducted in an inert atmosphere, which does not contain O₂.

According to the present invention a Te-rich surface is not needed to obtain a non-rectifying contact if the contact is made by depositing on top of CdTe film a thin layer of a highly conducting p-type semiconductors such as Sb₂Te₃ or As₂Te₃. A good non-rectifying contact is obtained on a clean CdTe surface if at least 100 nm thick layer of Sb₂Te₃ or As₂Te₃ is deposited by sputtering at a substrate temperature respectively of 250-300°C and 200-250°C. Sb₂Te₃ grows naturally p-type with a resistivity of 10⁻⁴ Ωcm, while As₂Te₃ grows p-type with a resistivity of 10⁻³ Ωcm. The contact procedure is completed by covering the low resistivity p-type semiconductor with at least 100 nm of Mo, as common practice in the art. A thin layer of Mo is needed in order to have a low sheet-resistance on the back-contact.

As a source for the CdS and CdTe materials used to form the respective layers by sputtering or CSS a granulate material can be used, as common practice in this field. However, in view of the drawbacks mentioned above when operating in this way, according to a particularly preferred aspect of the invention a new sublimation source can be used which consists of a compact block obtained by melting and solidifying the material in an oven able to sustain a temperature higher than the melting temperature of the material. The procedure to prepare the CdS compact block is as follows: pieces of CdS are put in a graphite container of the desired volume together with boron oxide (B₂O₃) , which is a low melting point material (450°C) and exhibits a very low vapour pressure when melted. Since boron oxide has a density lower than that of CdS in the molten state, it floats over CdS and covers CdS completely upon cooling. In this way, CdS covered by B₂O₃, if it is put into an oven containing an inert gas at pressure higher than 50 atm, does not evaporate even at a temperature higher than its melting point. Since CdS melts at a temperature of 1750°C, the oven is heated up to a temperature of 1800°C or more and then cooled down to room temperature. In this way, a unique compact block of CdS is obtained which results to be particularly suitable for use as a sublimation source in a close-spaced sublimation system. CdS films prepared with this type of source resulted to be very smooth and completely free of dust. The CdS films used to prepare the CdTe/CdS solar cells are typically 100 nm thick. The substrate temperature is kept at 200-300°C when CdS is prepared by sputtering and at 480-520°C when it is prepared by close-spaced-sublimation. The sputtered CdS layer needs an annealing at 500°C in an atmosphere containing O₂ in order for the CdS/CdTe solar cell to exhibit a high efficiency. In the case CdS is prepared by close-spaced sublimation, O₂ is introduced in the sublimation chamber during the deposition. The role of O₂ is not known, but it is presumed to passivate the CdS grain boundaries.

In a preferred embodiment of the invention, the CdTe source too is a compact block obtained by melting and solidifying pieces of CdTe in an oven under high pressure as described previously. Since CdTe melts at 1120°C, the oven needs to be heated up to 1200°C in order to have a complete melting of the CdTe pieces. CdTe films are deposited on top of CdS by close-spaced sublimation at a substrate temperature of 480-520°C. Deposition rates during the CdTe growth are typically 4 µm/min. In this way 8 µm of CdTe are deposited in 2 min.

By following the procedure described above several solar cells have been prepared by using as a substrate a 1 inch square low-cost soda-lime glass.

A typical area of these cells is 1 cm². The finished cells are generally put under 10-20 suns for several hours at a temperature of 180°C in the open-circuit-voltage (V_{oc}) conditions. No degradation has been notified but rather a 20% or more increase in the efficiency has been found.

The efficiency of these cells are in the range 12%-14% with open-circuit-voltages (V_{oc}) larger than 800 mV, short-circuit-currents (J_{sc}) of 22-25 mA/cm² and fill-factors (ff) ranging from 0.6 to 0.66.

### Example

A cell exhibiting a 14% efficiency has been prepared in the following way: a soda-lime glass has been covered by 500nm of In₂O₃:F (fluorine-doped) deposited at 500°C substrate temperature as described above. 100 nm of CdS have been deposited by sputtering at 300°C substrate temperature and annealed for 15 min at 500°C in 500mbar of Ar containing 20% of 0₂. 8 µm of CdTe have been deposited on top of CdS by CSS at a substrate temperature of 500°C. Both CdS and CdTe films are produced from a compact block source as described above. A treatment with 150 nm of CdCl₂ has been done in an Ar atmosphere as described above. Finally a back contact has been created, without any etching, by depositing in sequence by sputtering 150 nm of Sb₂Te₃ and 150 nm of Mo.

After one hour under 10 suns at a temperature of 180°C in open-circuit conditions the solar cell prepared in this way exhibited the following parameters:
- V_{oc}: 852 mv
- J_{sc}: 25 mA/cm²
- ff: 0.66
- efficiency: 14 %

The techniques used in this process such as sputtering and close-spaced sublimation are both fast, reproducible and easily scalable.

Sputtering systems capable to cover 1x0.5 m² area glass are already commercial, while close-spaced sublimation , which at a laboratory scale can cover easily 20x20 cm² area glass, does not give any problem in being scaled up to 1x0.5 m². An in-line process can work well if a large area glass is made to move slowly over the different sources namely TCO, CdS, CdTe, Sb₂Te₃ or As₂Te₃ and Mo. In order to make a series connection between the single cells the in-line system should also contain three laser scribing processes, the first after the TCO deposition, the second one before the back-contact deposition and the third one at the end of the process. An important part of the process according to the present invention is that no use is made of acids or liquids and, as a consequence, the process can operate on a continuous basis without the interruption which is needed to make the etching in acid or in a Br-methanol solution.

## Claims

1. Process for the large-scale production of CdTe/CdS thin film solar cells, said films being deposited as a sequence on a transparent substrate, comprising the steps of:
- depositing a film of a transparent conductive oxide (TCO) on said substrate;
- depositing a film of CdS on said TCO film;
- depositing a film of CdTe on said CdS film;
- treating said CdTe film with CdCl2;
- depositing a back-contact film on said treated CdTe film;
the process being **characterised in that** the treatment of the CdTe film with CdCl₂ comprises the following steps:
- forming a layer of CdCl₂ on the CdTe film by evaporation, while keeping the substrate at room temperature;
- annealing said CdCl₂ layer in a vacuum chamber at 380-420°C and 300-1000 mbar under inert gas atmosphere;
- removing the inert gas from said chamber to produce vacuum condition, while the substrate is kept to a temperature of 350-420°C whereby any residual CdCl₂ is evaporated from the CdTe film surface.

2. The process according to claim 1, wherein said CdCl₂ layer is 100-200 nm thick

3. The process according to claims 1 or 2, wherein the annealing of the CdCl₂ layer is carried out for 15-20 min.

4. The process according to any one of the previous claims, wherein the inert gas is Ar.

5. The process according to any one of the previous claims, wherein wherein the back-contact film is formed by a Sb₂Te₃ layer covered by a layer of Mo.

6. The process according to claim 5, wherein said Sb₂Te₃ layer is formed by sputtering at 250-300°C.

7. The process according to any one of the previous claims, wherein the back-contact film is formed by a As₂Te₃ layer covered by a layer of Mo.

8. The process according to claim 7, wherein said As₂Te₃ layer is formed by sputtering at 200-250°C

9. The process according to any of the previous claims, wherein the transparent conductive oxide is In₂O₃ doped with fluorine.

10. The process according to claim 9, wherein the TCO layer is formed by sputtering in an inert gas atmosphere containing hydrogen and a gaseous fluoroalkyle compound.

11. The process according to claim 10, wherein a mixture of Ar and hydrogen is used, in which hydrogen is comprised between 1 and 3% vol.% and the flouoroalkyle compound is CHF₃ .

12. The process according to any one of the previous claims, wherein, as a source material for the formation of the CdS and the CdTe films by close-spaced sublimation, a Cds or, respectively, CdTe material in the form of a compact block is used.

13. The process according to claim 12, wherein said compact block CdS (or CdTe) material is formed by covering with boron oxide pieces of CdS (or CdTe) material, heating the covered material to a temperature higher than its melting point under inert gas atmosphere and a pressure higher than 50 atm and then cooling down to room temperature, whereby the material is solidified in a compact block form.

14. The process according to any one of the previous claims, wherein said transparent substrate is soda-lime glass.

## Patentansprüche

1. Verfahren zur großtechnischen Herstellung von CdTe/CdS-Dünnschicht-Solarzellen, welche Schichten als Abfolge auf einem transparenten Substrat aufgetragen werden, enthaltend die Schritte:
- Auftragen einer Schicht eines transparenten leitenden Oxids (TCO) auf dem Substrat;
- Auftragen einer Schicht von CDs auf der TCO-Schicht;
- Auftragen einer Schicht von CdTe auf der CD-Schicht;
- Behandeln der CdTe-Schicht mit CdCl₂;
- Auftragen einer Rückwärtskontaktschicht auf der behandelten CdTe-Schicht in Verbindung;
welches Verfahren **dadurch gekennzeichnet ist, dass** die Behandlung der CdTe-Schicht mit CdCl₂ die folgenden Schritte enthält:
- Ausbilden einer Schicht von CdCl₂ auf der CdTe-Schicht durch Aufdampfen, während das Substrat auf Raumtemperatur gehalten wird;
- Annealen der CdCl₂-Schicht in einer Vakuumkammer bei 380 - 420°C und 300 - 1000 mbar in einer Inertgasatmosphäre;
- Entfernen des Inertgases aus der Kammer, um eine Vakuumbedingung zu erzeugen, während das Substrat auf einer Temperatur von 350 - 420 °C gehalten wird, wodurch jegliches verbleibendes CdCl₂ von CdTe-Schichtoberfläche verdampft wird.

2. Verfahren nach Anspruch 1, wobei die CdCl₂-Schicht 100 - 200 Nanometer dick ist.

3. Verfahren nach Anspruch 1 oder 2, wobei das Annealen der CdCl₂-Schicht für 15 - 20 Minuten ausgeführt wird.

4. Verfahren nach einem der vorhergehenden Ansprüche, wobei das Inertgas Ar ist.

5. Verfahren nach einem der vorhergehenden Ansprüche, wobei die Rückwärtskontaktschicht durch eine Sb₂Te₃-Schicht gebildet wird, die von einer Schicht aus MO bedeckt ist.

6. Verfahren nach Anspruch 5, wobei die Sb₂Te₃-Schicht durch Sputtern bei 250 - 300°C gebildet wird.

7. Verfahren nach einem der vorhergehenden Ansprüche, wobei die Rückwärtskontaktschicht durch eine As₂Te₃-Schicht gebildet wird, die von einer Schicht aus MO bedeckt ist.

8. Verfahren nach Anspruch 7, wobei die As₂Te₃-Schicht durch Sputtern bei 200 - 250 °C gebildet wird.

9. Verfahren nach einem der vorhergehenden Ansprüche, wobei das transparente leitende Oxid In₂O₃ dotiert mit Fluor ist.

10. Verfahren nach Anspruch 9, wobei die TCO-Schicht durch Sputtern in einer Inertgasatmosphäre gebildet wird, die Wasserstoff und einen gasförmigen Fluoroalkyl-Bestandteil enthält.

11. Verfahren nach Anspruch 10, wobei eine Mischung aus Ar und Wasserstoff benutzt wird, worin Wasserstoff zwischen 1 und 3 Vol.-% enthalten ist, und der das Fluoroalkyl-Bestandteil CHF₃ ist.

12. Verfahren nach einem der vorhergehenden Ansprüche, wobei als Ausgangsstoff für die Bildung der CdS- und der CdTe-Schichten durch closed-space Sublimation ein CdS- oder entsprechend CdTe-Material in der Form eines kompakten Blockes benutzt wird.

13. Verfahren nach Anspruch 12, wobei das Kompaktblock-CdS-(oder CdTe-) Material gebildet wird durch Bedecken von CdS- (oder CdTe-) Material mit Boroxidstücken, Heizen des bedeckten Materials auf eine Temperatur höher als seinen Schmelzpunkt in einer Inertgasatmosphäre und einem Druck von mehr als 50 atm, und dann Abkühlen auf Raumtemperatur, wodurch das Material in einer Kompaktblockform verfestigt wird.

14. Verfahren nach einem der vorhergehenden Ansprüche, wobei das transparente Substrat Kalknatronglas ist.

## Revendications

1. Procédé pour la production à grande échelle de piles solaires en films couches minces de CdTe/CdS, lesdits films étant déposés séquentiellement sur un substrat transparent, comprenant les étapes suivantes :
- dépôt d'un film d'un oxyde conducteur transparent (TCO) sur ledit substrat ;
- dépôt d'un film de CdS sur ledit film de TCO ;
- dépôt d'un film de CdTe sur ledit film de CdS ;
- traitement du dit film de CdTe avec du CdCl₂ ;
- dépôt d'un film contact arrière sur ledit film de CdTe traité ;
le procédé étant **caractérisé en ce que** le traitement du film de CdTe avec du CdCl₂ comprend les étapes suivantes :
- formation d'une couche de CdCl₂ sur le film de CdTe, par évaporation, tout en maintenant le substrat à la température ambiante ;
- recuit de ladite couche de CdCl₂ dans une chambre à vide à 380-420°C et sous 300-1000 millibars sous atmosphère de gaz inerte ;
- élimination du gaz inerte de ladite chambre pour obtenir des conditions de vide, tout en maintenant le substrat à une température de 350-420°C, ce en quoi tout CdCl₂ résiduel est évaporé de la surface du film de CdTe.

2. Le procédé selon la revendication 1, où ladite couche de CdCl₂ a une épaisseur de 100-200 nanomètres.

3. Le procédé selon l'une des revendications 1 et 2, où le recuit de la couche de CdCl₂ est effectué perdant 15-20 minutes.

4. Le procédé selon l'une quelconque des revendications précédentes, où le gaz inerte est de l'Argon.

5. Le procédé selon l'une quelconque des revendications précédentes, où le film contact arrière est constitué d'une couche de Sb₂Te₃ recouverte d'une couche de Mo.

6. Le procédé selon la revendication 5, où ladite couche de Sb₂Te₃ est obtenue par pulvérisation à 250-300°C.

7. Le procédé selon l'une quelconque des revendications précédentes, où le film contact arrière est constitué d'une couche de As₂Te₃ recouverte d'une couche de Mo.

8. Le procédé selon la revendication 7, où ladite couche de As₂Te₃ est obtenue par pulvérisation à 200-250°C.

9. Le procédé selon l'une quelconque des revendications précédentes, où l'oxyde conducteur transparent est du In₂O₃ dopé au Fluor.

10. Le procédé selon la revendication 9, où la couche de TCO est obtenue par pulvérisation sous atmosphère de gaz inerte contenant de l'Hydrogène et un composé de fluoroalkyle gazeux.

11. Le procédé selon la revendication 10, où un mélange d'Argon et d'Hydrogène est utilisé, dans lequel l'Hydrogène est compris entre 1 et 3% en vol. en % et le composé de flouoroalkyle est du CHF₃.

12. Le procédé selon l'une quelconque des revendications précédentes, où, comme matériau source pour la formation des films de CdS et de CdTe par sublimation en espace fermé, est utilisé un matériau de CdS ou, respectivement, de CdTe sous forme d'un bloc compact.

13. Le procédé selon la revendication 12, où ledit matériau de CdS (ou CdTe) en bloc compact est obtenu par recouvrement de morceaux de CdS (ou CdTe) avec de l'oxyde de Bore, en chauffant le matériau recouvert à une température supérieure à son point de fusion sous une atmosphère de gaz inerte et une pression supérieure à 50 atmosphères et ensuite en refroidissant jusqu'à la température ambiante, ce en quoi le matériau est solidifié sous une forme de bloc compact.

14. Le procédé selon l'une quelconque des revendications précédentes, où ledit substrat transparent est du verre à base de chaux sodée.
